(19) Europäisches Patentamt
European Patent Office
Office européen des brevets

(11) **EP 4 572 536 A1**

(12) **EUROPEAN PATENT APPLICATION**

(43) Date of publication:
**18.06.2025 Bulletin 2025/25**

(21) Application number: **24216140.4**

(22) Date of filing: **28.11.2024**

(51) International Patent Classification (IPC):
**H05B 45/20** (2020.01)   **H05B 47/155** (2020.01)
**H05B 47/16** (2020.01)   **H01L 25/075** (2006.01)

(52) Cooperative Patent Classification (CPC):
**H05B 45/20; H05B 47/155; H05B 47/16;** F21K 9/00;
F21Y 2113/10; F21Y 2115/10; H10H 29/24;
H10H 29/8512

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 01.12.2023   US 202363605034 P
22.12.2023   US 202363613992 P
27.11.2024   US 202418963070

(71) Applicant: **Seoul Semiconductor Co., Ltd.
Gyeonggi-do 15429 (KR)**

(72) Inventors:
• **JANG, BoRaml
15429 Ansan-si (KR)**
• **KO, MiSo
15429 Ansan-si (KR)**
• **CHOI, EunMi
15429 Ansan-si (KR)**

(74) Representative: **Stolmár & Partner
Patentanwälte PartG mbB
Blumenstraße 17
80331 München (DE)**

(54) **LIGHT EMITTING APPARATUS**

(57)   A light emitting apparatus includes at least one light emitting device, wherein natural light similarity (S) of light emitted from the light emitting apparatus ranges from -2.5 to 1.

【FIG. 9】

Natural light similarity, Wavelength [nm]

EP 4 572 536 A1

**Description**

[Technical Field]

The disclosed technology relates to a light emitting apparatus and, more particularly, to a light emitting apparatus capable of providing natural light illumination.

[Background Art]

In recent years, nitride semiconductors have been widely used as a base material for light emitting devices, such as light emitting diodes. Since nitride semiconductors can have various energy band-gaps depending on the composition ratio of Group III elements, it is possible to realize light with various wavelengths by controlling the composition ratio of elements, such as Al, Ga, In, or others.

For an active layer, a multi-quantum well (MQW) structure may be used and an emission wavelength of a light emitting device may be determined according to the composition ratio of nitride semiconductors in well layers of the multi-quantum well structure.

With the development of light emitting diodes for wattage (W) level lighting, lighting devices (appliances) using such light emitting diodes can emit light with sufficient brightness. In recent years, such lighting devices have been developed to be used not only in domestic applications but also in industrial and vehicle applications and it is expected that more lighting devices will employ light emitting diodes in the future.

Meanwhile, there is an increasing demand for technologies that can implement white light similar to natural light using light-emitting device.

[Disclosure]

[Technical Problem]

Embodiments of the disclosed technology can provide a light emitting apparatus for lighting similar to natural light.

Embodiments of the disclosed technology can realize a light emitting apparatus that emits light similar to natural light corresponding to each time of day.

Embodiments of the disclosed technology can provide a light emitting apparatus having a vivid color gamut.

Embodiments of the disclosed technology can provide a highly reliable light emitting apparatus that protects a light emitting device from an external environment.

Embodiments of the disclosed technology can efficiently realize a high quality light emitting apparatus in consideration of human visual sensitivity.

[Technical Solution]

In accordance with one aspect of the disclosed technology, a light emitting apparatus includes at least one light emitting device, wherein natural light similarity (S) of light emitted from the light emitting apparatus is defined by Equation 1:

$$\text{Natural Light Similarity (S)} = 1 - \frac{L(x_k)}{ref(x_k)}, \qquad \text{---Equation (1)}$$

where $x_k$ = wavelength
$L(x_k)$ = normalized spectral radiant flux of emission light
$ref(x_k)$ = normalized spectral radiant flux of natural light; and
wherein the natural light similarity (S) may range from -2.5 to 1.

The wavelength ($x_k$) may range from 380 nm to 780 nm.

In one embodiment, a root mean square (RMS) of the natural light similarity (S) may be defined by Equation 2:

$$\text{RMS of natural light similarity (S)} = \sqrt{\frac{1}{(b-a)}\sum_{k=a}^{b}\left(1 - \frac{L(xk)}{ref(xk)}\right)^2} \quad \text{---Equation (2)}$$

wherein, in Equation 2, a and b are integer numbers representing wavelength limits of the spectrum given in nm, like a = 380 and b = 780.

The root mean square (RMS) of the natural light similarity (S) may be less than or equal to 0.8.

In one embodiment, the light emitting apparatus may include a first light emitting device and a second light emitting device having different correlated color temperatures, wherein the natural light similarity (S) of a light emitting device having a higher correlated color temperature (CCT) among the first light emitting device and the second light emitting device may be close to 0.

In one embodiment, the root mean square (RMS) may have the greatest value in the blue wavelength band (a = 400, b = 480).

In one embodiment, the root mean square (RMS) may have the lowest value in the green-yellow wavelength band (a = 480, b = 590).

In one embodiment, the light emitting apparatus may include a plurality of light emitting devices configured to emit light having different correlated color temperatures.

In one embodiment, each of the light emitting devices may include a light emitting diode configured to generate light and a wavelength converter covering a light exit surface of the light emitting diode.

In one embodiment, the light emitting apparatus may further include a controller configured to control a light intensity ratio of the plurality of light emitting devices for different times of day.

In one embodiment, at least one of the plurality of light emitting devices may be configured to emit first emission light having a first correlated color temperature and at least one of the remaining light emitting devices may be configured to emit second emission light having a second correlated color temperature higher than the first correlated color temperature.

In one embodiment, mixed light of the first emission light and the second emission light may have a root mean square (RMS) between a root mean square (RMS) of the first emission light and a root mean square (RMS) of the second emission light.

In one embodiment, the root mean square (RMS) may have the lowest value during a time period of noon.

In one embodiment, the root mean square (RMS) may have the greatest value for a time period of sunrise/sunset.

In one embodiment, the light emitting devices may have an average color rendering index (Ra) of 90 or more.

In accordance with another aspect of the disclosed technology, a light emitting apparatus may include at least one light emitting device, wherein a root mean square (RMS) of a normalized deviation between radiant fluxes of light emitted from the light emitting apparatus and natural light at each wavelength may be less than or equal to 0.8.

In one embodiment, a root mean square (RMS) of natural light similarity (S) may be defined by Equation 2:

$$\text{RMS of natural light similarity (S)} = \sqrt{\frac{1}{(b-a)} \sum_{k=a}^{b} \left(1 - \frac{L(xk)}{ref(xk)}\right)^2}, \text{ --- Equation}$$

$$(2)$$

where $x_k$ = wavelength

$L(x_k)$ = normalized spectral radiant flux of emission light

$ref(x_k)$ = Normalized spectral radiant flux of natural light.

In one embodiment, the wavelength ($x_k$) may range from 380 nm to 780 nm and the root mean square (RMS) may have the greatest value in the blue wavelength band ranging from 400nm to 480nm.

In one embodiment, the root mean square (RMS) may have the lowest value in the green-yellow wavelength band ranging from 480nm to 590nm.

In accordance with a further aspect of the disclosed technology, a light emitting apparatus may include a plurality of light emitting devices configured to emit light having different correlated color temperatures, and a controller configured to control a light intensity ratio of the plurality of light emitting devices for different times of day.

In one embodiment, the controller may be configured to control a power ratio or a duty ratio applied to the plurality of light emitting devices.

In accordance with still another aspect of the disclosed technology, a light emitting apparatus includes: a substrate; and one or more light emitting devices disposed on one surface of the substrate, wherein the light emitting devices include a first light emitting device and a second light emitting device having different correlated color temperatures; at least one of the light emitting devices includes a light emitting diode and a wavelength converter covering one surface of the light emitting diode; and wherein natural light similarity (S) of light emitted from the light emitting devices is defined by Equation 1 and the first light emitting device and the second light emitting device have different natural light similarity (S) values.

$$\text{Natural Light Similarity (S)} = 1 - \frac{L(x_k)}{ref(x_k)}, \qquad \text{--- Equation (1)}$$

where $x_k$ = wavelength
$L(x_k)$ = normalized spectral radiant flux of emission light
$ref(x_k)$ = normalized spectral radiant flux of natural light.

In one embodiment, a root mean square (RMS) of the natural light similarity (S) may be defined by Equation 2:

$$\text{RMS of natural light similarity (S)} = \sqrt{\frac{1}{(b-a)} \sum_{k=a}^{b} \left(1 - \frac{L(xk)}{ref(xk)}\right)^2}, \qquad \text{---Equation}$$

$$(2)$$

where a = 380 nm and b = 780 nm.

The root mean square (RMS) of the natural light similarity (S) may be less than or equal to 1.

In one embodiment, the second light emitting device may be located in a color coordinate region bounded by (0.41, 0.365), (0.415, 0.422), (0.48, 0.44), and (0.47, 0.38), and the first light emitting device may be located in a color coordinate region bounded by (0.3, 0.3), (0.3, 0.35), (0.365, 0.395), and (0.36, 0.336).

In one embodiment, the first light emitting device may have a smaller root mean square (RMS) value than the second light emitting device.

In one embodiment, the first light emitting device may emit first emission light and the second light emitting device may emit second emission light.

In one embodiment, mixed light of the first emission light and the second emission light may have a correlated color temperature between a correlated color temperature of the first light emitting device and a correlated color temperature of the second light emitting device.

In one embodiment, the mixed light may have a root mean square (RMS) between a root mean square (RMS) of the first emission light and a root mean square (RMS) of the second emission light.

In one embodiment, the light emitting apparatus may further include a controller configured to control a light intensity ratio of the plurality of light emitting devices.

In one embodiment, at least one of the plurality of light emitting devices may emit first emission light having a first correlated color temperature and at least one of the remaining light emitting devices may emit second emission light having a second correlated color temperature higher than the first correlated color temperature.

In one embodiment, the root mean square (RMS) of the first emission light may be lower than that of the second emission light.

In one embodiment, the wavelength converter may include at least two phosphors having at least two different excitation wavelengths.

In one embodiment, the excitation spectral range of the phosphors may have a range that can overlap with at least one 0 point of the natural light similarity (S) of the light emitting device.

In one embodiment, the natural light similarity may be 0 at least at one point in a red light region.

In accordance with still another aspect of the disclosed technology, a light emitting apparatus may include: a substrate; and one or more light emitting devices disposed on one surface of the substrate, wherein at least one of the light emitting devices includes a light emitting diode and a wavelength converter covering one surface of the light emitting diode; and natural light similarity (S) of light emitted from the light emitting devices is defined by Equation 1:

$$\text{Natural Light Similarity (S)} = 1 - \frac{L(x_k)}{ref(x_k)}, \qquad \text{---Equation (1)}$$

where $x_k$ = wavelength
$L(x_k)$ = normalized spectral radiant flux of emission light
$ref(x_k)$ = normalized spectral radiant flux of natural light.

The natural light similarity (S) may be 0 at two or more points.

In one embodiment, a root mean square (RMS) of the natural light similarity (S) may be defined by Equation 2 and may be less than or equal to 1.

$$\text{RMS of natural light similarity (S)} = \sqrt{\frac{1}{(b-a)}\sum_{k=a}^{b}\left(1-\frac{L(xk)}{ref(xk)}\right)^2}, \text{---Equation}$$

(2)

where a = 380 nm and b= 780 nm.

In one embodiment, the natural light similarity (S) may have a minimum value in the blue wavelength band.

In one embodiment, the natural light similarity (S) may be 0 at least at one point in both a green and a red light regions.

In one embodiment, the natural light similarity (S) may have an absolute value of the natural light similarity (S) is equal to or less than 0.1 in a wavelength range from 480nm to 590nm.

In one embodiment, the light emitting devices may include a first light emitting device and a second light emitting device having different correlated color temperatures, wherein the first light emitting device emits first emission light and the second light emitting device emits second emission light.

In one embodiment, mixed light of the first emission light and the second emission light may have a correlated color temperature between a correlated color temperature of the first light emitting device and a correlated color temperature of the second light emitting device.

In one embodiment, the mixed light may have a root mean square (RMS) between a root mean square (RMS) of the first emission light and a root mean square (RMS) of the second emission light.

In one embodiment, the light emitting apparatus may further include a controller configured to control a light intensity ratio of the plurality of light emitting devices.

In one embodiment, the first emission light may have a lower root mean square (RMS) than the second emission light.

In one embodiment, the mixed light may have a root mean square (RMS) in the green wavelength band between a root mean square (RMS) of the first emission light and a root mean square (RMS) of the second emission light.

In one embodiment, the wavelength converter may include at least two phosphors having at least two different excitation wavelengths.

In one embodiment, the excitation wavelengths of the phosphors may overlap with a point at which the natural light similarity (S) of the light emitting device is 0.

In one embodiment, the natural light similarity may be 0 at a point in a red light region.

[Effects of the Invention]

Embodiments of the disclosed technology provide a light emitting apparatus that can deliver illumination similar to natural light.

[Description of Drawings]

FIG. 1 is a graph showing the color coordinate space of natural light at different times from sunrise to sunset.

FIG. 2 is a diagram illustrating the sun's altitude and corresponding correlated color temperatures from sunrise to sunset.

FIG. 3A to FIG. 3C are graphs showing the correlated color temperature and resulting spectral distribution of natural light at specific times of day.

FIG. 4A to FIG. 4C are side cross-sectional views of a light emitting device of a light emitting apparatus according to an embodiment of the disclosed technology.

FIG. 5 is a plan view illustrating arrangement of light emitting devices of a light emitting apparatus according to one embodiment of the disclosed technology.

FIG. 6 is a side view of the light emitting apparatus according to the embodiment of the disclosed technology.

FIG. 7 is a graph depicting a driving ratio of light emitting devices over time in the light emitting apparatus according to the embodiment of the disclosed technology over time.

FIG. 8 and FIG. 9 are graphs illustrating natural light similarity depending on correlated color temperature.

FIG. 10 is a graph depicting the natural light similarity of mixed light of light emitted from light emitting devices configured to emit light with different CCTs.

FIG. 11A is a graph depicting spectral radiant intensity of the mixed light of light emitted from the light emitting devices configured to emit light with different CCTs.

FIG. 11B is a graph depicting changes in natural light similarity of the mixed light of light emitted from the light emitting devices configured to emit light with different CCTs.

FIG. 12A to FIG. 12D are graphs comparing the natural light similarity of light emitting devices at 6500K, 5000K, 4000K, and 2700K, respectively.

[Detailed Description]

In the following description, for the purposes of explanation, numerous specific details are set forth in order to provide thorough understanding of various exemplary embodiments or implementations of the disclosed technology. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

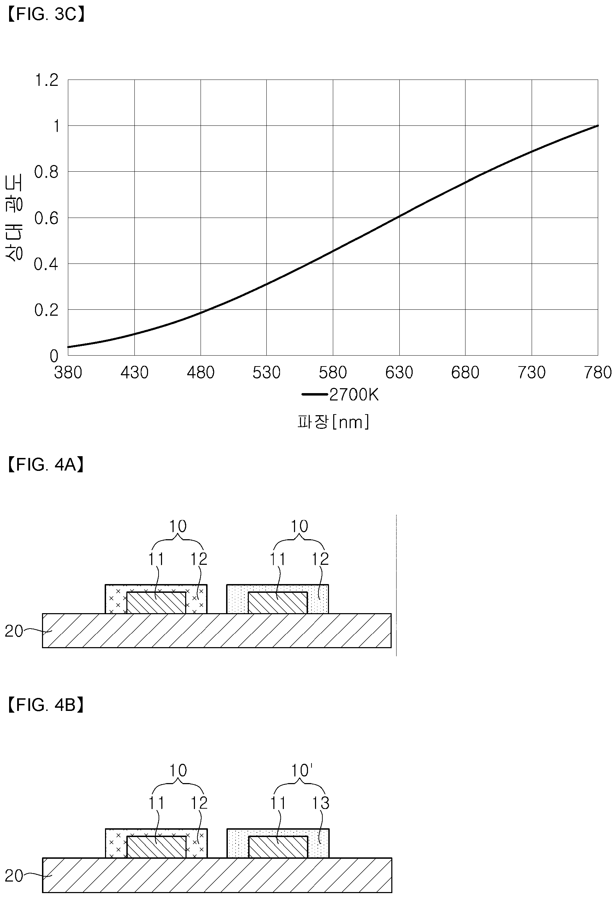

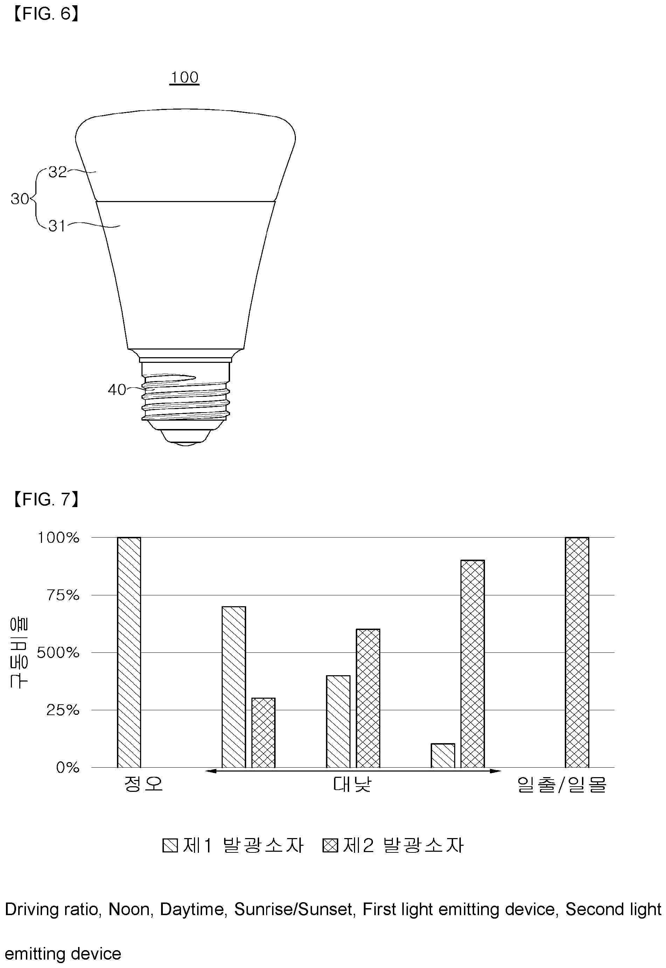

The disclosed technology provides a light emitting apparatus 100 (Fig. 6) including one or more light emitting devices 10 (Fig. 4A - 4D). Hereinafter, exemplary embodiments of the disclosed technology will be described in more detail with reference to the accompanying drawings.

The light emitting apparatus 100 refers to an illuminator that emits light similar to natural light, which may also be understood as sunlight. The light emitting apparatus 100 according to the disclosed technology may be configured to emit illuminating light having a spectrum similar to sunlight.

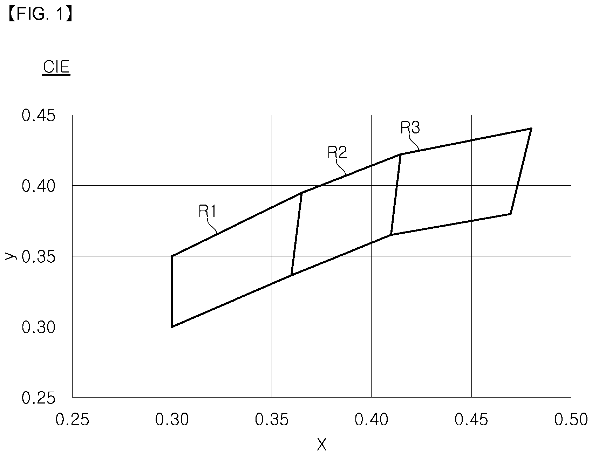

Referring to FIG. 1, the region of the natural light on the CIE color coordinates may vary since the sun's altitude changes throughout the day from sunrise to sunset.

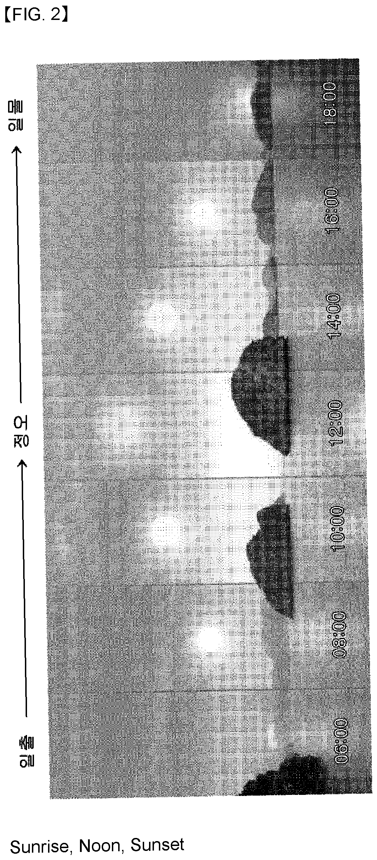

For example, as shown in FIG. 2, natural light is bluish at dawn, just before sunrise, and turns reddish as the sun begins to rise around 6 AM, with a correlated color temperature ranging about 2,000K to 3,000K.

During a time period of sunrise, natural light is reddish and has a relatively low color temperature, and can be located within a color coordinate region (region R3 in FIG. 1) bounded by (0.41, 0.365), (0.415, 0.422), (0.48, 0.44), and (0.47, 0.38) in CIE color coordinates.

After sunrise, around 12 noon, the sun is positioned due south (that is, at midday when seen from the northern hemisphere) and natural light appears bluish and can have a correlated color temperature of about 5,000K.

During a time period of noon, natural light has a blue color and a relatively high color temperature, and can be located within a color coordinate region (region R1 in FIG. 1) bounded by (0.3, 0.3), (0.3, 0.35), (0.365, 0.395), and (0.36, 0.336) in CIE color coordinates.

After midday and passing through the afternoon, when sunset begins around 6 PM, reddish natural light is generated again and can have a correlated color temperature of about 2,000K to 3,000K.

During a time period of sunset, natural light is reddish and has a relatively low color temperature and can be located within a color coordinate region bounded by (0.41, 0.365), (0.415, 0.422), (0.48, 0.44), and (0.47, 0.38) in CIE color coordinates (region R3 in FIG. 1).

Between noon and sunset, that is, during daylight hours, natural light can have a correlated color temperature (for example, 4,000K) that lies between the color temperature of natural light during a time period of noon and the color temperature of natural light around sunset, and may be located within a color coordinate region (region R2 in FIG. 1) bounded by (0.36, 0.336), (0.365, 0.395), (0.415, 0.422), and (0.41, 0.365) in the CIE color coordinates.

In other words, natural light refers to light that has different correlated color temperatures at different times of day from sunrise to sunset, and may have various spectra for each time of day.

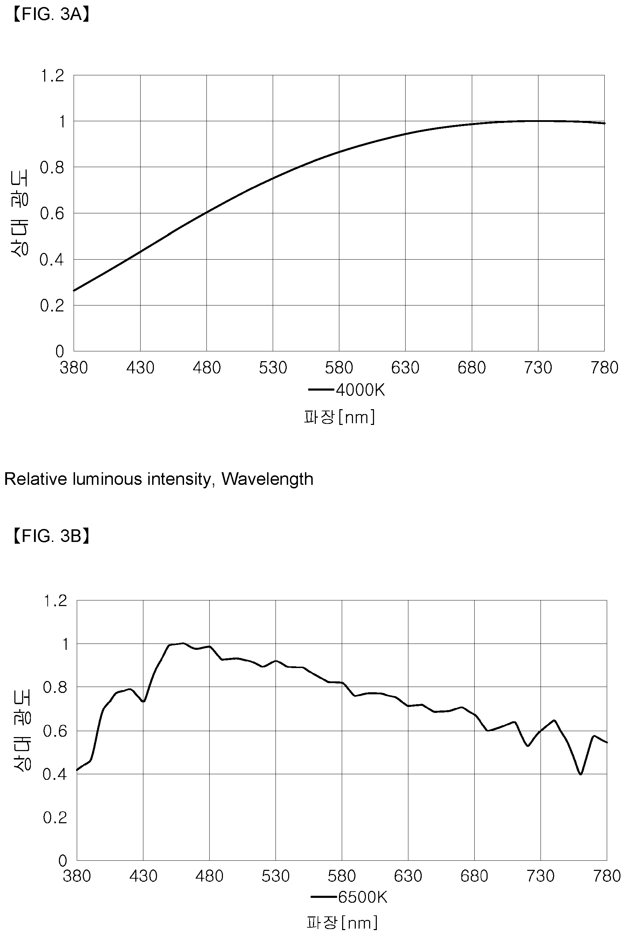

For example, FIG. 3A to FIG. 3C illustrate spectral distributions of natural light depending on the correlated color temperature of natural light, in which FIG. 3A illustrates a spectral distribution of natural light with a correlated color temperature of 4,000K, FIG. 3B illustrates a spectral distribution of natural light with a correlated color temperature of 6,500K, and FIG. 3C illustrates a spectral distribution of natural light with a correlated color temperature of 2,700K.

Referring to FIG. 3A, natural light with a correlated color temperature of 4,000K exhibits a spectral distribution biased to a relatively long wavelength and has a redder color than the natural color of FIG. 3B, which exhibits a spectral distribution biased to a relatively short wavelength. Referring to FIG. 3C, the spectral distribution of natural light with a low correlated color temperature of 2,700K is biased to the reddest light and thus can be understood as the spectral distribution of natural light around sunrise or sunset.

The light emitting apparatus 100 according to the disclosed technology is configured to emit light having a spectrum similar to the spectrum of natural light, which varies over time of day, and may include one or more light emitting devices 10, 10', more preferably a plurality of light emitting devices 10, 10'.

Each of the light emitting devices 10, 10' may include a light emitting diode 11 that generates light.

The light emitting diode 11 may be disposed on a substrate 20. The substrate 20 is a circuit board on an upper surface of which one or more light emitting diodes 11 are mounted, and may include an insulation layer and interconnections for electrical connection to the light emitting diodes 11, and may include circuits for power supply to the light emitting diodes 11 to drive the light emitting diodes 11.

The substrate 20 may be formed on an upper surface thereof with a pad for mounting the light emitting diode 11 and on a lower surface thereof with a pad to be mounted on another substrate.

The substrate 20 may be formed in a multilayer structure and may be formed to various thicknesses, as needed.

The light emitting diode 11 is disposed on one surface of the substrate 20 and may be formed in various configurations, such as a light emitting diode chip that generates light.

The light emitting diode 11 may include semiconductor layers formed on a growth substrate. The growth substrate may be selected from any substrates that allow growth of nitride semiconductors thereon and may include, for example, a heterogeneous substrate, such as a sapphire substrate, a silicon substrate, a silicon carbide substrate, or a spinel substrate, and may also include a homogeneous substrate, such as a gallium nitride substrate, an aluminum nitride substrate, or others.

The light emitting diode 11 may include a first conductivity type semiconductor layer, an active layer, and a second conductivity type semiconductor layer.

The first conductivity type semiconductor layer may be a semiconductor layer grown on one surface of the growth substrate and a buffer layer (not shown) may be further formed between the first conductivity type semiconductor layer and the growth substrate. The buffer layer may include a nitride semiconductor, such as GaN, and may be grown by metal organic chemical vapor deposition (MOCVD). The buffer layer can improve crystallinity of the semiconductor layers grown on the growth substrate in a subsequent process and can also act as a seed layer for growth of nitride semiconductor layers on a heterogeneous substrate.

The first conductivity type semiconductor layer may include a nitride semiconductor, such as (Al, Ga, In)N, and may be grown on the growth substrate through a technique, such as MOCVD, MBE, HVPE, or others. In addition, the first conductivity type semiconductor layer may be doped with at least one type of n-type dopant, such as Si, C, Ge, Sn, Te, Pb, or others. However, it should be understood that the disclosed technology is not limited thereto. Alternatively, the first conductivity type semiconductor layer may also be doped with a p-type dopant to become an opposite conductivity type.

Furthermore, the first conductivity type semiconductor layer may be composed of a single layer or multiple layers. When the first conductivity type semiconductor layer is composed of multiple layers, the first conductivity type semiconductor layer may include a superlattice layer. Furthermore, the first conductivity type semiconductor layer may further include a contact layer, a modulation doping layer, an electron implantation layer, or others.

The active layer refers to a light emitting layer formed on the first conductivity type semiconductor layer and may have a multi-quantum well structure (MQW).

The active layer may include a nitride semiconductor, such as (Al, Ga, In)N, and may be grown on the first conductivity type semiconductor layer through a technique, such as MOCVD, MBE, HVPE, or others.

The active layer may include a quantum well structure (QW) including at least two barrier layers and at least one well layer. Furthermore, the active layer may include a multi-quantum well structure (MQW) including a plurality of barrier layers and a plurality of well layers.

The wavelength of light emitted from the active layer may be adjusted by controlling the composition ratio of the nitride semiconductor layer of the well layer. Here, the well layer may include a nitride semiconductor containing indium (In).

The well layer is disposed between the barrier layers and has a smaller bandgap energy than the barrier layer.

The well layer may include or be formed of $In_xGa_{(1-x)}N$ (0<x< 1), in which the composition ratio (x) of In may be controlled according to the wavelength of light emitted from the active layer.

The barrier layers and the well layers are alternately stacked one above another, preferably alternately stacked at least twice. A barrier layer and a well layer adjacent thereto may constitute a pair.

The second conductivity type semiconductor layer may be a semiconductor layer formed on the active layer.

The second conductivity type semiconductor layer may include a nitride semiconductor, such as (Al, Ga, In)N, and may be grown through a technique, such as MOCVD, MBE, HVPE, or others.

The second conductivity type semiconductor layer may be doped to become a conductivity type opposite to the conductivity type of the first conductivity type semiconductor layer. For example, the second conductivity type semiconductor layer may be doped with p-type dopants, such as Mg.

It should be understood that the structure of the light emitting diode 11 according to the disclosed technology is not limited to the above structure and may be implemented in various structures. It will be apparent that the light emitting diode 11 may be modified into various structures including a flip-chip structure, a vertical structure, a lateral structure, or others.

To enhance the natural light similarity (S), the light emitter 400 may include at least one light-emitting diode 11 with a peak wavelength. This peak wavelength may be within the blue wavelength range of 400 nm to 480 nm. By increasing the intensity of the blue region, it is possible to improve the natural light similarity (S) in the blue light region. Additionally, to further enhance the natural light similarity in the blue region, the light emitter device 10 may include at least two light emitting diode 11 with different peaks. In this case, the difference in peak wavelengths between the two light emitting diodes 11 can be 10 nm or less, allowing improvement in natural light similarity without increasing chromatic aberration. In addition, the light emitting diodes 11 may have a half-width of 13 or more and 20 or less. Through this, the natural light similarity (S) can be increased without lowering the color purity.

By way of example, the light emitting device 10 may further include a wavelength converter 12 that covers a light exit surface of the light emitting diode 11.

The wavelength converter 12 refers to a layer that converts the wavelength of light emitted from the light emitting diode 11, may have various configurations, and may be formed of a wavelength conversion material in a light transmitting resin, without being limited thereto.

To further improve the natural light similarity (S), the light emitter device 10 may include a wavelength converter 12 containing at least two types of phosphors. These phosphors can include trace amounts of luminescent ions in the host materials, with the luminescent ions differing between the two phosphors. For example, to enhance the natural light similarity (S) in the green-yellow wavelength range (480 nm to 590 nm), the wavelength converter 12 may include at least one type of green or yellow phosphor. Such phosphors can include YAG, LSN, LYSN, SiAlON, GYAG, LuAG, ZnZ, or $Gd_3Ga_5O_{12}$, with $Ce^{3+}$ as a possible luminescent ion. Additionally, to increase the intensity in the red wavelength range and improve the natural light similarity (S) for the red wavelength range, the wavelength converter 12 may include at least one type of red phosphor. Examples of red phosphors include $(Ca,Sr)AlSiN_3+$, $La_2O_2S+$, $(La,Sr)AlO_3$, or $CaAl_2O_4$, with $Eu^{2+}$ or $Eu^{3+}$ used as luminescent ions.

Moreover, to further enhance the natural light similarity (S) in the red wavelength range, two types of red phosphors with different peaks may be used. In this case, the difference in peak wavelengths between the two types of red phosphors can be 20 nm or more, increasing the intensities in both short-wavelength and long-wavelength red wavelength range and improving the natural light similarity (S).

Moreover, to enhance the natural light similarity (S) in the green-yellow wavelength region, two types of phosphors, one green and one yellow, can be used. These green and yellow phosphors may have peak differences of 10 nm or more, improving the intensities in the green and yellow wavelength regions and further enhancing the natural light similarity (S).

Light emitted from the light emitting device 10 may be a mixture of light emitted from the light emitting diode 11 and light converted by the wavelength converter 12. For example, the light emitting diode 11 may be a blue light emitting diode that has a center wavelength in the blue wavelength band and the wavelength converter 12 may include a yellow phosphor excited by blue light to emit yellow light.

In another example, the light emitting diode 11 may be a blue light emitting diode that has a center wavelength in the blue wavelength band and the wavelength converter 12 may include a green phosphor excited by blue light to emit green light and a red phosphor excited by blue light to emit red light.

It should be understood that the above combination of the light emitting diode 11 and the wavelength converter 12 is provided as a possible example and that the disclosed technology is not limited thereto.

In another example, the light emitting device 10' may include a light transmitting layer13 covering the light exit surface of the light emitting diode 11 instead of the wavelength converter 12.

The light transmitting layer 13 may be formed of a light transmissive resin and may cover the light exit surface of the light emitting diode 11.

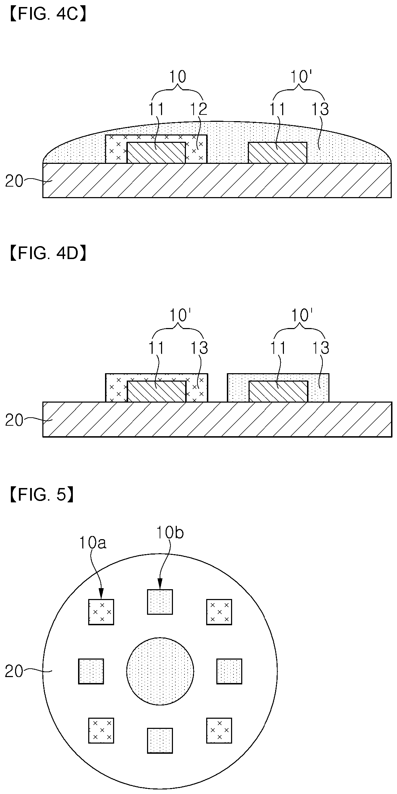

Referring to FIG. 4A to FIG. 4C, the light emitting apparatus 100 according to the disclosed technology includes a plurality of light emitting devices 10, 10', in which at least one of the plurality of light emitting devices 10, 10' may include the wavelength converter 12. Alternatively, all of the light emitting devices 10' do not include the wavelength converter 12 or may include the light transmitting layer13, as shown in FIG. 4D. When the light emitting device 10' includes the light transmitting layer13, the light transmitting layer13 may also cover the other light emitting device 10, 10' adjacent thereto, as shown in FIG. 4C.

Referring to FIG. 4B, the light emitting device 10 including the wavelength converter 12 may have a wider spectral region than the light emitting device 10' including the light transmitting layer13. By way of example, a full wavelength at half maximum (FWHM) of a spectrum converted by the wavelength converter 12 of the light emitting device 10 may be wider than a full wavelength at half maximum of a spectrum having passed through the light transmitting layer13 of the light emitting device 10'. In addition, the light emitting device 10 including the wavelength converter 12 may have a higher luminous flux than the light emitting device 10' including the light transmitting layer 13, and may have a higher color rendering index (CRI). In addition, due to these characteristics, the light emitting device 10 including the wavelength converter 12 may have a natural light similarity (S) closer to 0 than the light emitting device 10' including the light transmitting layer 13 and may have a smaller root mean square (RMS) of the natural light similarity (S) than the light emitting device 10'.

In addition, when the light emitting apparatus 100 according to the disclosed technology includes the plurality of light emitting devices 10, 10', the light emitting devices 10, 10' may be arranged in a row, in a matrix, in a circumferential direction, or in various patterns, as shown in FIG. 4A to 4D and FIG. 5.

Further, peak and dominant wavelengths of light emitted from the plurality of light emitting devices 10, 10' may be the same or different from each other.

For example, one of the plurality of light emitting diodes 11 may be a blue light emitting diode that emits blue light and has a center wavelength in the blue wavelength band. In another example, one of the plurality of light emitting diodes 11 may be a green light emitting diode that emits green light and has a center wavelength in the green wavelength band. In another example, one of the plurality of light emitting diodes 11 may be a red light emitting diode that emits red light and has a center wavelength in the red wavelength band. In another example, one of the plurality of light emitting diodes 11 may be a UV light emitting diode that emits UV light and has a center wavelength in the ultraviolet wavelength band. In another example, one of the plurality of light emitting diodes 11 may be a light emitting diode including a plurality of active layers and having a plurality of peak wavelengths.

The light emitting apparatus 100 may include a plurality of light emitting devices 10, 10' configured to emit light having different correlated color temperatures. That is, one of the plurality of light emitting devices 10, 10' may be configured to emit light having a different color temperature than the other light emitting device 10, 10'.

For example, at least one of the plurality of light emitting devices 10, 10' may be a first light emitting device 10a configured to emit first emission light having a first correlated color temperature, and at least one of the remaining light emitting devices 10, 10' may be a second light emitting device 10b configured to emit second emission light having a second correlated color temperature lower than the first correlated color temperature. Here, the CIE color coordinates of the first light emitting device 10a may be located within region R1 and the CIE color coordinates of the second light emitting device 10b may be located within region R3 in FIG. 1. As an example, the first light-emitting device 10a may have a color temperature similar to that of natural daylight, such as at noon, while the second light-emitting device 10b may have a color temperature similar to natural daylight during sunset or sunrise. The first light emitting device 10a may have a color temperature in the range of 5000K to 7000K, while the second light emitting device 10b may have a color temperature in the range of 3000K to 2500K.

Referring to FIG. 5, the first light emitting device 10a and the second light emitting device 10b may be alternately spaced apart from each other and mixed light of the first emission light emitted from the first light emitting device 10a and the second emission light emitted from the second light emitting device 10b may be finally emitted from the light emitting apparatus 100. The mixed light may have a color temperature similar to natural daylight between sunrise and noon or between sunrise and sunset. The color temperature of this mixed light may range from 5000K to 3000K.

The light emitting apparatus 100 according to the disclosed technology may further include a controller configured to control a light intensity ratio of the plurality of light emitting devices 10a, 10b.

In other words, by controlling the light intensity ratio of the first light emitting device 10a and the second light emitting device 10b, the controller may control the color temperature of the final emission light to a desired color temperature between the first correlated color temperature and the second correlated color temperature. That is, the controller may control the light emitting apparatus to have a desired color coordinate between the region R1 and the region R3 in FIG. 1.

As described above, since natural light has a correlated color temperature and spectrum that varies for each time of day from sunrise to sunset, the controller may control the light intensity ratio of the plurality of light emitting devices 10 for each time of day to realize lighting similar to natural light for each time of day.

Specifically, referring to FIG. 7, when the first light emitting device 10a emits first emission light (blue light) having a higher correlated color temperature of 5,000K to 7,000K and the second light emitting device 10b emits second emission light (red light) having a lower correlated color temperature of 2,700K to 3,000K, the controller may realize lighting similar to a cool white color of natural light at noon by driving only the first light emitting device 10a at a ratio of 100% at noon (around 12:00 AM). Here, the CIE color coordinates of the first light emitting device 10a may be located within the region R1 in FIG. 1 and the CIE color coordinates of the second light emitting device 10b may be located within the region R3 in FIG. 1. Here, by driving only the first light emitting device 10a at a ratio of 100%, the color coordinates of the light emitting apparatus 100 may be located within the region R1 in FIG. 1.

Likewise, the controller may realize lighting similar to a neutral white color of natural light during daylight (between noon and sunset) by driving the first light emitting device 10a and the second light emitting device 10b in a ratio of, for example, 7:3, 4:6, or 1:9. Here, when the driving ratio of the first light emitting device 10a is higher than that of the second light emitting device 10b, the light emitting apparatus 100 may have a high color temperature close to the color temperature of the first light emitting device 10a and the color coordinates of the light emitting apparatus 100 may be located in the region R1 or at a left side in the region R2 close to the region R1 in FIG. 1. In addition, when the driving ratio of the first light emitting device 10a is lower than the driving ratio of the second light emitting device 10b, the light emitting apparatus 100 may have a low color temperature close to the color temperature of the second light emitting device 10b, and the color coordinates of the light emitting apparatus 100 may be located within the region R3 in FIG. 1 or at a right side of the region R2 close to the region R3 in FIG. 1.

Further, the controller may realize lighting similar to a warm white color of natural light around sunrise or sunset (around 6:00 AM or around 6:00 PM) by driving only the second light emitting device 10b at a driving ratio of 100%. By driving only the second light emitting device 10b at a ratio of 100%, the color coordinates of the light emitting apparatus 100 may be located within the region R3 in FIG. 1.

Control of the driving ratios of the first light emitting device 10a and the second light emitting device 10b may be achieved through power control (voltage (V) or current (I) control) or duty ratio control (PWM control), whereby the light intensity ratio by the first light emitting device 10a and the second light emitting device 10b can be controlled.

In FIG. 7, the driving ratio is provided by way of example and may be changed depending on the type, number, and operation time of the light emitting devices 10a, 10b disposed in the light emitting apparatus 100.

Referring to FIG. 6, the light emitting apparatus 100 may include a housing 30 that accommodates the plurality of light emitting devices 10a, 10b and a socket 40 that supplies power to the plurality of light emitting devices 10a, 10b.

For example, the housing 30 may include a housing body 31, in which the substrate 20 is disposed, and a cover 32 coupled to an opening of the housing body 31. The cover 32 may include a diffusing agent to allow colors of the light emitting devices 10a,10b to be naturally mixed with each other. The housing body 31 may be further provided with a heat sink to dissipate heat generated from the plurality of light emitting devices 10.

The socket 40 may provide electrical connections for power supply to the plurality of light emitting devices 10 through the substrate 20 on which the light emitting devices 10 are disposed.

It should be understood that the housing 30 and the socket 40 shown in FIG. 6 are provided by way of example and may be modified in various ways depending on application.

On the other hand, similarity between light emitted from the light emitting apparatus 100 according to the disclosed technology (mixed light of light emitted from the plurality of light emitting devices 10, 10') and natural light may be defined as natural light similarity (S) according to Equation 1:

$$\text{Natural Light Similarity (S)} = 1 - \frac{L(x_k)}{ref(x_k)}, \qquad \text{--- Equation (1)}$$

where $x_k$ = wavelength
$L(x_k)$ = normalized spectral radiant flux of emission light
$ref(x_k)$ = normalized spectral radiant flux of natural light.

The normalized spectral radiant flux $ref(x_k)$ of natural light may be obtained with reference to the highest radiant flux value in the spectrum of natural light.

The normalized spectral radiant flux $L(x_k)$ of emission light may be obtained by normalizing the spectral radiant flux of the emission light such that an area of a normalized luminous flux of natural light, which is obtained by multiplying the normalized spectral radiant flux $ref(x_k)$ of natural light by the weight considering human visual sensitivity is equal to the area obtained by multiplying the spectral radiant flux of the light emitting apparatus 100 by the weight considering human visual sensitivity. In other words, the normalized luminous flux of $ref(x_k)$ and the normalized luminous flux of $L(x_k)$ are normalized to have the same value.

The natural light similarity (S) may be a measure for evaluating the degree of similarity between light emitted from the light emitting apparatus 100 and natural light.

Here, the wavelength ($x_k$) may include a blue light region (400 nm to 480 nm), a green/yellow light region (480 nm to 590 nm), and an orange/red light region (590 nm to 750 nm), and may include, for example, a zone in the range of 380 nm to 780 nm.

Ref($x_k$) is the normalized spectral radiant flux of natural light at the same color temperature as L($x_k$) and may be a spectral radiant flux normalized with reference to the maximum radiant flux.

L($x_k$) is the normalized spectral radiant flux of the emission light and may be a spectral radiant flux normalized to have the same luminous flux as Ref($x_k$).

When L($x_k$) is the same as Ref($x_k$), the natural light similarity (S) is 0. Thus, it can be concluded that as the natural light similarity (S) approaches 0, the emitted light is evaluated to be more similar to natural light.

Here, the light emitted from the light emitting apparatus 100 according to the disclosed technology may have a natural light similarity (S) in the range of -2.5 to 1 and the light emitting apparatus 100 can be realized to emit light similar to natural light in each wavelength band.

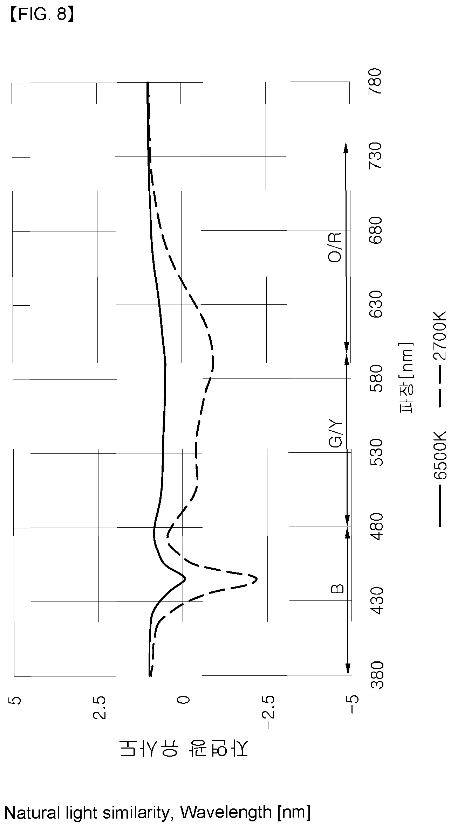

Specifically, FIG. 8 shows a graph depicting wavelength-dependent natural light similarity (S) of the light emitted from the light emitting apparatus 100 according to the disclosed technology at correlated color temperatures of 6,500K and 2,700K and it can be seen that the natural light similarity (S) has a value between -2.5 and 1 at both correlated color temperatures of 6500K and 2700K.

By way of example, when the light emitting device 10 includes a light emitting diode 11 configured to emit blue light and a wavelength converter 12 including a yellow phosphor excited by blue light to emit yellow light, light emitted from the light emitting device 10 may have the lowest natural light similarity value in the blue light region (400 nm to 480 nm) (that is, the natural light similarity (S) has the lowest value in the blue light region (400 nm to 480 nm)) and may have at least two points in the blue light region (400 nm to 480 nm) at which the light is most similar to natural light (that is, at which the natural light similarity (S) of the light is 0). Furthermore, the light emitted from the light emitting device 10 includes light in the green/yellow light region (480 nm to 590 nm) excited by the wavelength converter 12, in which the minimum value of the natural light similarity (S) in this region may be greater than the minimum value of the natural light similarity (S) in the blue light region (400 nm to 480 nm), whereby the light emitting apparatus can realize improved natural light similarity through increases in natural light similarity in a high visual sensitivity region.

In another example, when the light emitting device 10 includes a light emitting diode 11 configured to emitting blue light and a wavelength converter 12 including a green phosphor excited by blue light to emit green light and a red phosphor excited by blue light to emit red light, light emitted from the light emitting device 10 may have the lowest natural light similarity value in the blue light region (400 nm to 480 nm) (that is, the natural light similarity (S) has the lowest value in the blue light region (400 nm to 480 nm)), and may have two or more points in the blue light region (400 nm to 480 nm) at which the light is most similar to natural light (that is, at which the natural light similarity (S) of the light is 0), thereby improving color expression of the blue light region. Further, the light emitted from the light emitting device 10 includes light in the green/yellow light region (480 nm to 590 nm) and the orange/red light region (590 nm to 750 nm) excited by the wavelength converter 12, in which the minimum value of the natural light similarity (S) in this region may be greater than the minimum value of the natural light similarity (S) in the blue light region (400 nm to 480 nm), whereby the light emitting apparatus can realize improved natural light similarity through increase in natural light similarity in the green/yellow light region (480 nm to 590 nm) corresponding to a high visual sensitivity region.

On the other hand, the light emitting device 10', which includes the light transmitting layer 13 instead of the wavelength converter 12, can increase the color rendering index in a certain color band as an auxiliary light source. By way of example, the light emitting device 10' may be a red light source and the natural light similarity (S) of the light emitting apparatus 100 with the light emitting devices 10, 10' driven together may have two or more points in the red light region, at which the light is most similar to natural light, (that is, at which the natural light similarity (S) of the light is 0), thereby realizing a more vivid red color.

Referring again to Equation 1, since the natural light similarity (S) is a value obtained by dividing the difference between ref($x_k$) and L($x_k$) by ref($x_k$), the natural light similarity (S) can be understood as a normalized deviation between the radiant flux of the light emitted from the light emitting apparatus 100 and the radiant flux of natural light at each wavelength.

The root mean square (RMS) of the natural light similarity (S) may be defined according to Equation 2 below, where the smaller the root mean square (RMS) (closer to 0), the more similar light is to natural light.

$$\text{RMS of natural light similarity (S)} = \sqrt{\frac{1}{(b-a)}\sum_{k=a}^{b}\left(1 - \frac{L(xk)}{ref(xk)}\right)^2}, \text{---Equation}$$

$$(2)$$

where a = 380 nm and b = 780 nm.

Here, the wavelength ($x_k$) may be defined in the range of 380 nm and 780 nm, without being limited thereto. The wavelength ($x_k$) may be set according to the spectral range of the light emitting apparatus 100, preferably in the range of 410 nm to 680 nm.

By way of example, when the light emitting apparatus 100 includes first and second light emitting devices 10a, 10b configured to emit light having first and second correlated color temperatures different from each other, respectively, a root mean square (RMS) of natural light similarity (S) of light emitted from the first light emitting device 10a may be smaller than a root mean square (RMS) of natural light similarity (S) of light emitted from the second light emitting device 10b. Here, mixed light of the light emitted from the first light emitting device 10a and the light emitted from the second light emitting device 10b may have a correlated color temperature between the first correlated color temperature and the second correlated color temperature. Further, the natural light similarity (S) of the mixed light may have a value between the natural light similarity (S) of the light emitted from the first light emitting device 10a and the natural light similarity (S) of the light emitted from the second light emitting device 10b. Since the root mean square (RMS) of the mixed light has a smaller value than the root mean square (RMS) of the light emitted from the second light emitting device 10b, the light emitting apparatus can realize improved natural light similarity.

The root mean square (RMS) of the natural light similarity (S) of the light emitting apparatus 100 according to the disclosed technology may be less than or equal to 0.8. If the value is greater than 0.8, the light spectrum may be less similar to sunlight spectrum and reduce color rendering accuracy.

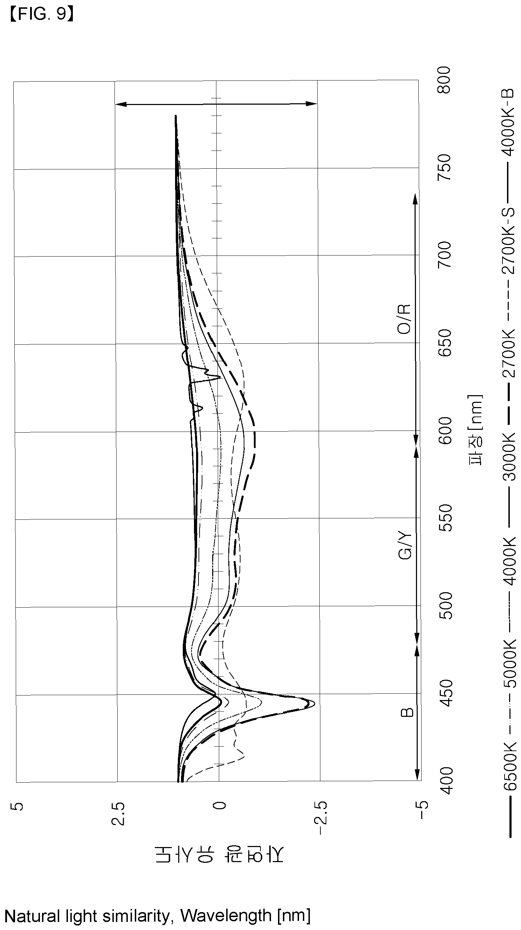

As the correlated color temperature (CCT) of the emitted light increases, the root mean square (RMS) of the natural light similarity (S) of the light may be closer to 0 and the light exhibits a spectrum more similar to natural light. That is, the higher the CCT, the smaller the root mean square (RMS) value and the more similar to natural light, as shown in FIG. 8 and FIG. 9.

Referring to FIG. 8, it can be seen that the natural light similarity (S) of the emitted light has a larger value when the correlated color temperature (CCT) of the emitted light is 6,500K than when the CCT is 2,700K. That is, as the correlated color temperature (CCT) increases, the natural light similarity (S) may be closer to 0 and the emitted light may exhibit a spectrum more similar to natural light. Further, the light emitting apparatus 100 having a spectrum similar to natural light may have a relatively small variation in natural light similarity (S) in each wavelength region. Furthermore, the natural light similarity (S) of the emitted light may become 0 at least at two points in all spectral regions. When the emitted light has a spectrum similar to the spectrum of natural light, the natural light similarity (S) of the emitted light becomes 0 at many points. This relationship is also shown in FIG. 9. Referring to FIG. 9, the natural light similarity (S) of the emitted light may become 0 at least at one point in the blue light region (B) and may become 0 at least at one point in the green light region (G/Y) and in the red light region (O/R). The light emitting apparatus 100 can realize improved color rendering by emitting light similar to natural light such that the natural light similarity (S) of the emitted light becomes 0 at points in at least two regions of trichromatic colors of light (where the natural light similarity (S) of the emitted light becomes 0).

FIG. 9 shows natural light similarity (S) at wavelengths of 2,700K, 3,000K, 4,000K, 5,000K, and 6,500K in various light emitting apparatuses 100. From FIG. 9, it can be seen that the higher the correlated color temperature (CCT), the closer the natural light similarity (S) to 0 and the more similar the spectrum is to natural light. In particular, in FIG. 9, 5,000K indicates an example of the light emitting apparatus 100 including a plurality of phosphors applied to increase the natural light similarity (S), in which the root mean square (RMS) of the natural light similarity (S) may have a value of 0.5 or less.

For example, referring to Table 1, the natural light similarity (S) at 6,500K, corresponding to the color temperature of natural light during a time period of noon, may range from -1.5 to 1; the natural light similarity (S) at 3,000K and 4,000K, corresponding to the color temperatures of natural light during midday, may range from -2.38 to 1 and a value in the range of -1.05 to 1, respectively; and the natural light similarity (S) at 2,700K, corresponding to the color temperature of natural light during a time period of sunrise/sunset, may range from -2.5 to 1.

Referring to FIG. 3b, the natural light spectrum of midday light may have the highest relative intensity in the blue wavelength range. Therefore, the first light-emitting device 10a with a color temperature similar to that of midday light may have higher intensity in the blue wavelength range compared to other ranges. Furthermore, the peak intensity in the blue wavelength range may be the highest, and the peak intensity in the blue wavelength range may be 1.5 to 2.2 times higher than in other ranges. Additionally, to increase the intensity in the blue wavelength range, multiple blue light emitting diodes can be used and the difference in the peak wavelengths between multiple blue light emitting diodes may be 10 nm or less. Furthermore, the first light-emitting device 10a may have a less intensity in the green-yellow region and red wavelength regions compared to the blue wavelength region, thereby increasing the natural light similarity (S) at the high color temperature. This may reduce chromatic aberration and improve the natural light similarity (S).

Referring to FIG. 3c, the natural light spectrum of sunrise/sunset light may have the highest intensity in the red wavelength range. Therefore, the second light-emitting device 10b, with a color temperature similar to that of sunrise/sunset light, may have higher intensity in the red wavelength range compared to other ranges. Furthermore, the peak intensity in the red wavelength range may be 2 to 2.5 times higher than in other peak wavelength. Additionally, to increase the intensity in the red wavelength range, at least two types of phosphors may be used, with each having a different excitation peak wavelength, and the difference in excitation peak wavelengths between the two phosphors may be 10 nm or more. This may increase the intensity in the red region, improve red color gamut, and enhance natural light similarity (S). Furthermore, the second light emitting device 10b may have a higher content of red phosphor compared to the first light emitting device 10a in order to increase the intensity in the red wavelength range. For example, the number of phosphor particles in the region overlapping with the light emitting diode 11 in the second light emitting device 10b may be greater than in the first light emitting device 10a. This may increase the natural light similarity (S) in the red wavelength region.

Moreover, by using a light emitting diode 11 having a blue peak wavelength in the light-emitting device 10, the first light-emitting element 10a, with a color temperature similar to midday light, may have higher natural light similarity (S) compared to the second light-emitting device 10b, with a color temperature similar to sunrise/sunset light. That is, the difference between the maximum and minimum values of the natural light similarity (S) of the first light emitting device 10a may be smaller than that of the second light emitting device 10b. This can reduce the design complexity of the light emitting device using blue light-emitting diodes.

Table 1

|  | Correlated Color Temperature (CCT) | Natural light similarity (S) (-2.5 to 1) |
|---|---|---|
| Noon | 6,500K | -1.5 to 1 |
| Daylight | 4,000K | -2.05 to 1 |
|  | 3,000K | -2.38 to 1 |
| Sunrise/Sunset | 2,700K | -2.5 to 1 |

On the other hand, 4000K-B in FIG. 9 indicates a light emitting apparatus in which the light emitting device 10 includes KSF as a red phosphor, and has a high peak in the red light region, in which the natural light similarity (S) becomes 0 at least at one wavelength, thereby enabling expression of a vivid red color.

In addition, referring to FIG. 8 and FIG. 9, when the wavelength region is divided into the blue wavelength band (B, 400 nm to 480 nm), the green wavelength band (G/Y, 480 nm to 590 nm), and the red wavelength band (O/R, 590 nm to 750 nm), each region may have a different natural light similarity (S).

Here, the blue wavelength band (B, 400 nm to 480 nm) may refer to the blue light wavelength region, the green wavelength band (G/Y, 480 nm to 590 nm) may refer to the green and yellow light wavelength region, and the red wavelength band (O/R, 590 nm to 750 nm) may refer to the orange and red light wavelength region.

The natural light similarity (S) of the emitted light may have the lowest value in the blue wavelength band (B, 400 nm to 480 nm) and the emitted light may be most similar to natural light in the green wavelength band (G/Y, 480 nm to 590 nm) (that is, the natural light similarity (S) may be close to 0). This may mean that the emitted light has low natural light similarity in the blue wavelength band (B, 400 nm to 480 nm) and has the most similar spectrum to natural light in the green wavelength band (G/Y, 480 nm to 590 nm). As such, since human visual sensitivity is low in the blue light region, the light emitted from the light emitting apparatus 100 can be perceived to be relatively similar to natural light even when the natural light similarity (S) of the emitted light is low, thereby efficiently realizing a high quality light emitting apparatus 100.

Furthermore, when comparing the natural light similarity (S) in each of the blue wavelength band (B, 400 nm to 480 nm), the green wavelength band (G/Y, 480 nm to 590 nm), and the red wavelength band (O/R, 590 nm to 750 nm), the emitted light may have a natural light similarity (S) closest to 0 in the green wavelength band (G/Y, 480 nm to 590 nm), indicating that the emitted light is most similar to natural light in the green wavelength band. This is because the human eye is most sensitive in the green wavelength band (G/Y, 480 nm to 590 nm) and thus the natural light similarity in the green wavelength band (G/Y, 480 nm to 590 nm) is important in order to express color temperatures similar to natural light. Therefore, the natural light emitting devices 10, 10' may have a natural light similarity (S) closest to 0 in the green wavelength band (G/Y, 480 nm to 590 nm). In the green wavelength region, the natural light similarity (S) may vary at a gentler slope than in the blue and red wavelength regions, thereby reducing visual fatigue while providing a more comfortable light emitting apparatus 100. To improve the natural light similarity (S) in the green wavelength range (480nm-590nm), the wavelength converter 12 of the light-emitting device 10 may use phosphors with excitation peak wavelengths in the green wavelength range (G/Y, 480nm-590nm). The phosphors may include green or yellow phosphors, such as YAG, LSN, LYSN, SiAlON, GYAG, LuAG, or $Gd_3Ga_5O_{12}$. These phosphors may have excitation peak wavelengths within the green or yellow wavelength region, and the excitation wavelength spectrum of the phosphors may be designed to overlap with the point where the natural light similarity (S) of the light-emitting device becomes zero. This may enhance the natural light similarity (S) in the green wavelength range. The natural light similarity (S) may have an absolute value of 0.1 or less in the 480nm to 590nm range. This can reduce visual fatigue and enable the implementation of a light emitting apparatus 100 with high natural light similarity(S).

In addition, the light emitting apparatus 100 may have a lower natural light similarity (S) in the red wavelength band (O/R, 590 nm to 750 nm) than in the green wavelength band (G/Y, 480 nm to 590 nm). Since human visual sensitivity is lower in the red wavelength range than in the green wavelength range, the light emitting apparatus 100 emits light having higher intensity in the red wavelength range than natural light in order to express a vivid red color, thereby realizing a high color gamut. To implement this, the wavelength converter 12 may have a higher yellow phosphor content than red phosphor. For example, in the region overlapping with the light emitting diode 11, the number of yellow phosphor particles may be greater than the number of red phosphor particles. This can reduce production material costs while achieving a light emitting apparatus 100 with improved natural

For example, referring to Table 2, in the wavelength band of 380 nm to 780 nm, the root mean square (RMS) at 6,500K corresponding to the color temperature of natural light during a time period of noon may range from 0. 3 and 0.70; the root mean square (RMS) at 3,000K and 4,000K corresponding to the color temperatures of natural light during midday may range from 0.36 to 0.074 and in the range of 0.35 to 0.072, respectively, and the root mean square (RMS) at 2,700K corresponding to the color temperature of natural light during a time period of sunrise/sunset may range from 0.4 to 0.75.

Table 2

|  | Correlated Color Temperature (CCT) | Root Mean Square (RMS) (380 nm to 780 nm) |
|---|---|---|
| Noon | 6,500K | 0.3 to 0.70 |
| Daylight | 4,000K | 0.35 to 0.72 |
|  | 3,000K | 0.36 to 0.74 |
| Sunrise/Sunset | 2,700K | 0.40 to 0.75 |

In another aspect, the root mean square (RMS) may have the lowest value during midday, when the color temperature is relatively high, and may have the greatest value during a time period of sunrise/sunset, when the color temperature is relatively low.

In addition, when the wavelength region is divided into the blue wavelength band (B, 400 nm to 480 nm), the green wavelength band (G/Y, 480 nm to 590 nm), and the red wavelength band (O/R, 590 nm to 750 nm), each region may have a different root mean square (RMS).

The root mean square (RMS) may have the lowest value in the green wavelength band (G/Y, 480 nm to 590 nm). In addition, the root mean square (RMS) may have a higher value in the blue wavelength band (B, 400 nm to 480 nm) than in the green wavelength band. By way of example, the root mean square (RMS) may have the greatest value in the blue wavelength band. This may mean that the emitted light has low natural light similarity in the blue wavelength band (B, 400 nm to 480 nm) and has the most similar spectrum to natural light in the green wavelength band (G/Y, 480 nm to 590 nm). Thus, since the light emitting diodes 11 of the light emitting devices 10, 10' emit light in the blue wavelength band, in which the emitted light has the lowest natural light similarity and a narrow wavelength band due to the highest energy in the blue wavelength band, the root mean square (RMS) may have a great value in the blue wavelength band. As such, since human visual sensitivity is low in the blue light region, the light emitted from the light emitting apparatus 100 can be perceived to be relatively similar to natural light even when the natural light similarity (S) of the emitted light is low, thereby efficiently realizing a high quality light emitting apparatus 100. In addition, light in the green wavelength band may be light excited by the wavelength converter 12, and, since the excited light has a great full width at half maximum and is greatly affected by visual sensitivity, the natural light similarity of the light in the green wavelength band may have a flatter and lower root mean square (RMS) than the natural light similarity of light in other wavelength bands in the spectrum of the light emitting apparatus normalized to produce the same luminous flux as natural light. In addition, light in the red wavelength band may also be light excited by the wavelength converter 12 and, since the natural light similarity of light may decrease toward longer wavelengths, the natural light similarity of the light in the red wavelength band may have a relatively great root mean square (RMS).

For the light emitting apparatus 100 according to the disclosed technology including a plurality of light emitting devices 10, 10' having different correlated color temperatures (CCTs), light emitted from the light emitting apparatus 100 may have a value between the root mean squares (RMS) of light emitted from the light emitting devices 10, 10'.

For example, when at least one of the plurality of light emitting devices 10, 10' is configured to emit first emission light having a first correlated color temperature and at least one of the remaining light emitting devices 10, 10' is configured to emit second emission light having a second correlated color temperature higher than the first correlated color temperature, the light emitting apparatus 100 emits mixed light of the first emission light and the second emission light, in which the mixed light may have a root mean square (RMS) between a root mean square (RMS) of the first emission light and a root mean square (RMS) of the second emission light.

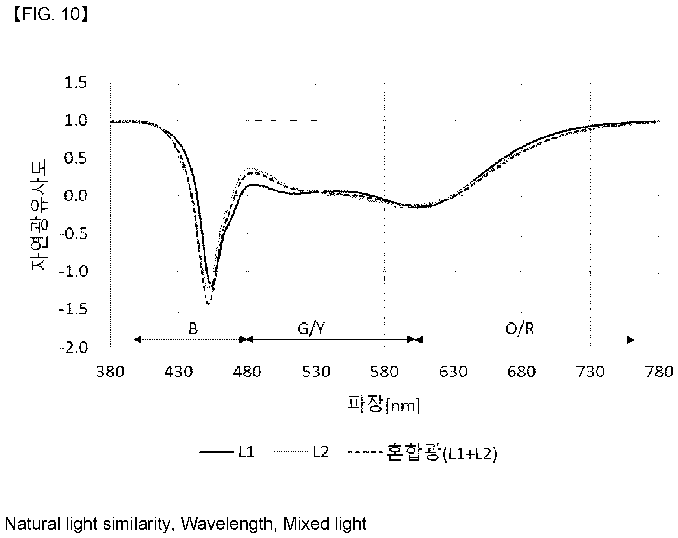

Specifically, FIG. 10 is a graph depicting the natural light similarity (S) of mixed light of light emitted from light emitting devices 10, 10' configured to emit light with different CCTs, for example, correlated color temperatures of 2,700K (L1) and 6,500K (L2). The light emitting device 10, 10' configured to emit light having a correlated color temperature of 2,700K may have a relatively great root mean square (RMS) and the natural light similarity (S) of the light may have a relatively small minimum value and may be less than the natural light similarity of the light having a correlated color temperature of 6,500K at most wavelengths; and the light emitting device 10, 10' configured to emit light having a correlated color temperature of 6,500K may have a relatively small RMS value and the natural light similarity (S) of the light may have a relatively great minimum value and may be greater than the natural light similarity of the light having a correlated color temperature of 2,700K at most wavelengths.

In FIG. 10, the mixed light is produced, for example, by mixing light emitted from the two light emitting devices 10, 10' and the natural light similarity of the mixed light having a correlated color temperature of 4,500K is shown, in which the root mean square (RMS) of the mixed light may be a value between the root mean square (RMS) values of the two light emitting devices. For the mixed light, the natural light similarity (S) may be improved in some regions over the natural light similarity (S) of pre-mixed light. In this case, the mixed light may be light having a correlated color temperature between 2,700K and 6,500K instead of being limited to 4,500K, and the root mean square (RMS) of the mixed light may also be a value between the root mean square (RMS) values of the two light emitting devices 10, 10'.

A difference between the root mean square (RMS) of the mixed light and the root mean square (RMS) values of the light emitted from the two light emitting devices 10, 10' in the blue wavelength band (B, 400 nm to 480 nm) may be less than 10%. For example, in the blue wavelength band (B, 400 nm to 480 nm), the root mean square (RMS) of the light emitted from the first light emitting device 10, 10' is 1.26, the root mean square (RMS) of the light emitted from the second light emitting device 10, 10' is 1.21, and the root mean square (RMS) of the mixed light is 1.15. Accordingly, the difference between the root mean square (RMS) of the mixed light and the root mean square (RMS) of the light emitted from each of the light emitting devices 10, 10' in the blue wavelength band may be less than 10%. Further, the difference between the minimum value of the natural light similarity (S) of the mixed light and the minimum value of the natural light similarity (S) of the light emitted from the two light emitting devices 10, 10' in the blue wavelength band B may be less than 0.6. The difference between the light emitted from the two light emitting devices 10, 10' and the mixed light in the blue wavelength band B may be minimized to maintain color balance in the blue light region.

In addition, in the green wavelength band (G/Y, 480 nm to 590 nm), the root mean square (RMS) of the mixed light may have a value between the root mean square (RMS) values of the light emitted from the two light emitting devices 10, 10'. For example, in the green wavelength band (G/Y, 480 nm to 590 nm), the root mean square (RMS) of the light emitted from the first light emitting device 10, 10' is 0.05, the root mean square (RMS) of the light emitted from the second light emitting device 10, 10' is 0.16, and the root mean square (RMS) of the mixed light is 0.13, which is between the root mean square (RMS) values of the light emitted from the two light emitting devices 10, 10'.

Further, in the green wavelength band (G/Y), the natural light similarity (S) of the mixed light may be in a region between the natural light similarity (S) of the light emitted from the first light emitting device 10 and the natural light similarity (S) of the light emitted from the second light emitting device 10'. Further, the natural light similarity (S) of the mixed light may intersect at least at one point with the natural light similarity (S) of the light emitted from the first light emitting device 10 and the natural light similarity (S) of the light emitted from the second light emitting device 10'. The mixed light produced by mixing the light emitted from these two light emitting devices 10, 10' may be combined to have a value between the natural light similarity (S) values of the light emitted from the light emitting devices 10, 10' and a value between the root mean square (RMS) values thereof.

As a result, it is possible to improve color balance and enhance the quality of a light source by leveling the natural light similarity (S) and the root mean square (RMS) in the green light region, where human vision is highly sensitive (by increasing the root mean square (RMS) of the mixed light above a relatively low RMS of the light emitted from the two light emitting devices 10, 10' and decreasing it of the mixed light below a relatively high RMS of the light emitted from the two light emitting devices 10, 10').

In addition, the mixed light may also have a natural light similarity of 0 at least at one point in the green wavelength band (G/Y), thereby enabling improvement in color rendering in the green light region.

Further, the root mean square (RMS) of the mixed light in the red wavelength band (R) may have a value between the root mean square (RMS) values of the light emitted from the two light emitting devices 10, 10'. Further, the natural light similarity (S) of the mixed light in the red wavelength band R may be in a region between the natural light similarity (S) of the light emitted from the first light emitting device 10, 10' and the natural light similarity (S) of the light emitted from the second light emitting device 10, 10'.

The mixed light produced by mixing the light emitted from these two light emitting devices 10, 10' may be combined to have a value between the natural light similarity (S) values of the light emitted from the light emitting devices 10, 10' and a value between the root mean square (RMS) values thereof. As a result, it is possible to improve color balance while improving quality of a light source through improvement in color rendering by leveling the natural light similarity (S) and the root mean square (RMS) (by increasing the root mean square (RMS) of the mixed light above a relatively low RMS of the light emitted from the two light emitting devices 10, 10' while decreasing the root mean square (RMS) of the mixed light below a relatively high RMS of the light emitted from the two light emitting devices 10, 10') in the red light region, which affects the color rendering index. In addition, the mixed light may also have a natural light similarity (S) of 0 at least at one point in the red wavelength band R, thereby improving color rendering in the red light region (for example, R9).

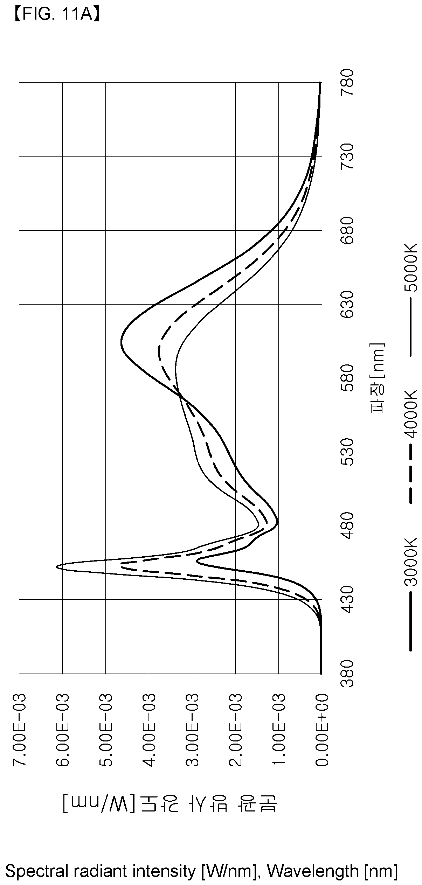

Next, FIG. 11A is a graph depicting the spectral radiant intensity (W/nm) of each light emitted from two light emitting devices 10, 10' configured to emit light having correlated color temperatures of 3,000K and 5,000K, and the spectral radiant intensity (W/nm) of mixed light (4,000K) of the light emitted from the two light emitting devices. From FIG. 11A, it can be seen that the spectral radiant intensity of the mixed light having a correlated color temperature of 4,000K has a value between the spectral radiant intensity (W/nm) values of the light having correlated color temperatures of 3,000K and 5,000K.

In the blue wavelength band (B, 400 nm to 480 nm), the spectral radiant intensity (W/nm) of light emitted from the light emitting device 10, 10' configured to emit light having a higher correlated color temperature may have a higher value than that of light emitted from the light emitting device 10, 10' configured to emit light having a lower color temperature. In addition, in the blue wavelength band (B, 400 nm to 480 nm), the spectral radiant intensity of the mixed light may be greater than that of the light of the light emitting device 10, 10' having a lower color temperature and may be less than that of the light of the light emitting device 10, 10' having a higher color temperature. Further, in the green wavelength band (G/Y, 480 nm to 590 nm), the spectral radiant intensity (W/nm) of the light of the light emitting device 10, 10' having a lower color temperature may be less than the light of light emitting device 10, 10' having a higher color temperature, and the spectral radiant intensity (W/nm) of the mixed light of the light emitted from the two light emitting devices 10, 10' may be greater than that of the light of the light emitting device 10, 10' having a lower color temperature and may be less than that of the light of the light emitting device 10, 10' having a higher color temperature. Furthermore, in the red wavelength band (O/R, 590 nm to 750 nm), the spectral radiant intensity (W/nm) of the light of the light emitting device 10, 10' having a lower color temperature may be greater than that of the light of the light emitting device 10, 10' having a higher color temperature, and the spectral radiant intensity (W/nm) of the mixed light of the light emitted from the two light emitting devices 10, 10' may have a value between the spectral radiant intensity (W/nm) values of the light emitted from the two light emitting devices 10, 10'. That is, the spectral radiant intensity (W/nm) of the mixed light in the red wavelength band (O/R, 590 nm to 750 nm) may be less than that of the light of the light emitting device 10, 10' having a lower color temperature and may be greater than that of the light of the light emitting device 10, 10' having a higher color temperature.

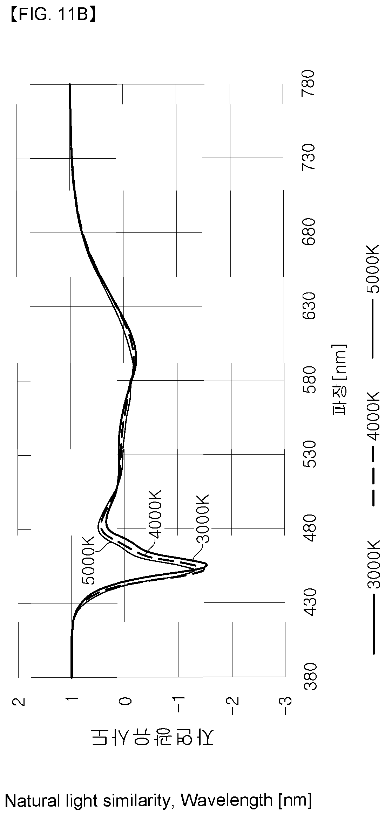

FIG. 11B is a graph depicting the natural light similarity (S) of each light emitted from two light emitting devices 10, 10' configured to emit light having color temperatures of 3,000K and 5,000K, and the natural light similarity (S) of mixed light (4,000K) of the light emitted from the two light emitting devices. From FIG. 11B, it can be seen that the natural light similarity (S) of the mixed light having a correlated color temperature of 4,000K has a value between the natural light similarity (S) values of the light having color temperatures of 3,000K and 5,000K.

In other words, referring to Table 3, the root mean square (RMS) of the mixed light may be less than the root mean square (RMS) of the light of the light emitting device 10, 10' having a lower color temperature and may be greater than the root mean square (RMS) of the light of the light emitting device 10, 10' having a higher color temperature.

Table 3

| | | | CCT | | |
|---|---|---|---|---|---|
| | Wavelength band (nm) | | Second light emitting device | Mixed light | First light emitting device |
| | | | 3,000K | 4,000K | 5,000K |
| RMS in each wave-length re-gion | Blue | 400 to 479 | 0.62 | 0.72 | 0.7 |
| | Green/Yellow | 480 to 589 | 0.10 | 0.18 | 0.16 |
| | Orang/Red | 590 to 750 | 0.61 | 0.55 | 0.57 |
| RMS | | | 0.61 | 0.60 | 0.59 |

For example, in the blue wavelength band (B, 400 nm to 480 nm), the light of the light emitting device 10, 10' having a lower color temperature may have a lower root mean square (RMS) and the light of the light emitting device 10, 10' having a higher correlated color temperature may have a higher root mean square (RMS). In addition, in the blue wavelength band (B, 400 nm to 480 nm), the mixed light may have a root mean square (RMS) that is greater than the lower root mean square (RMS) of the light emitted from the light emitting device 10, 10'. Also, the mixed light may have a root mean square (RMS) that is greater than the higher root mean square (RMS) of the light emitted from the light emitting device 10, 10'.

In addition, in the green wavelength band (G/Y, 480 nm to 590 nm), the light of the light emitting device 10, 10' having a lower color temperature may have a lower root mean square (RMS), the light of the light emitting device 10, 10' having a higher color temperature may have a higher root mean square (RMS). The mixed light of the light emitted from the at least two light emitting devices 10, 10 may have a root mean square (RMS) that is greater than the lower root mean square (RMS) of the light emitted from the light emitting device 10, 10'.

Further, in the red wavelength band (O/R, 590 nm to 750 nm), the light of the light emitting device 10, 10' having a lower color temperature may have a higher root mean square (RMS), the light of the light emitting device 10, 10' having a higher color temperature may have a lower root mean square (RMS). The mixed light of the light emitted from the two light emitting devices 10, 10 may have a root mean square (RMS) that is less than the higher root mean square (RMS) of the light emitted from the light emitting device 10, 10'. Also, the mixed light may have a root mean square (RMS) in the red wavelength band (O/R, 590 nm to 750 nm) that is less than the root mean square (RMS) of the light emitted from the light emitting device 10, 10'.

When comparing the root mean square (RMS) values in the wavelength bands in the spectrum of the mixed light and the spectra of the light emitted from the light emitting devices 10, 10', namely, the root mean square (RMS) values in the blue wavelength band (B, 400 nm to 480 nm), the green wavelength band (G/Y, 480 nm to 590 nm), and the red wavelength band (O/R, 590 nm to 750 nm), the root mean square (RMS) in the green wavelength band (G/Y, 480 nm to 590 nm) may have the lowest value. This is because the human eye is most sensitive in the green wavelength band (G/Y, 480 nm to 590 nm) and thus the natural light similarity in the green wavelength band (G/Y, 480 nm to 590 nm) is important in order to express color temperatures similar to natural light.

The light emitting apparatus 100 according to the disclosed technology may generate a variety of mixed light by suitably controlling the driving ratio of the plurality of light emitting devices 10, 10' having different correlated color temperatures, thereby realizing lighting similar to natural light for each time of day.

On the other hand, the light emitting devices 10, 10' in the light emitting apparatus 100 according to the disclosed technology may have luminous properties, particularly color rendering properties, which may be defined as an average color rendering index (Ra).

The light emitting devices 10, 10' may be high color gamut devices having an average color rendering index (Ra) of 90 or more, without being limited thereto. Although the high color gamut device having an average color rendering index (Ra) of 90 or higher can have a lower light output than the light emitting device, the high color gamut device has an advantage of providing lighting more similar to natural light.

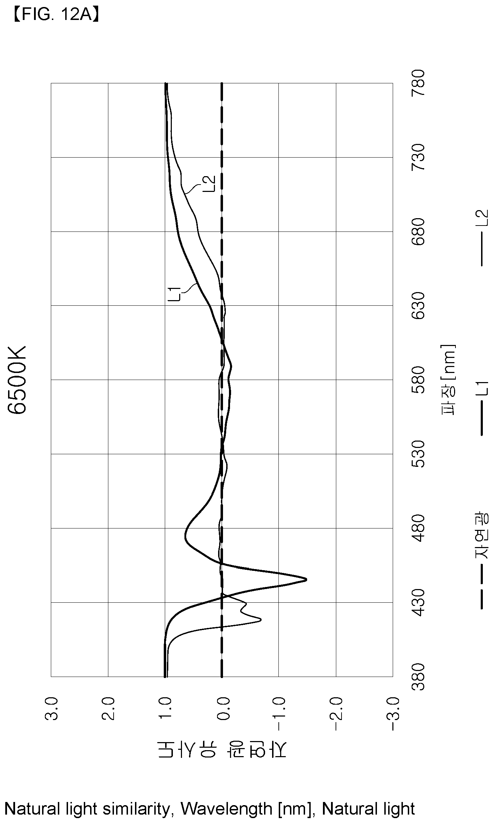

FIG. 12A shows natural light similarity (S) of natural light (ref), a light emitting device L1, and a high color gamut device L2 having an average color rendering index (Ra) of 90 or greater at a correlated color temperature of 6,500K.

Referring to FIG. 12A, it can be seen that the high color gamut device L2 has a natural light similarity (S) closer to 0 in all wavelength ranges than the light emitting device L1 to exhibit a spectrum similar to natural light and thus also has a small root mean square (RMS).

Referring to Table 4, it can be seen that, although both the high color gamut device L2 and the light emitting device L1 have the greatest root mean square (RMS) values in the blue wavelength band (400 nm to 479 nm), the high color gamut device L2 has a smaller root mean square (RMS) in each wavelength band than the light emitting device L1. The high color gamut device L2 may be manufactured to have a plurality of blue peaks in order to improve the root mean square (RMS) in the blue wavelength band B. The plurality of blue peaks may be formed using a plurality of chips having different peak wavelengths. Furthermore, a light emitting device having MQWs having different peak wavelengths in a single device may be used.

Further, when comparing the root mean square (RMS) values in the blue wavelength band (B, 400 nm to 480 nm), the green wavelength band (G/Y, 480 nm to 590 nm), and the red wavelength band (O/R, 590 nm to 750 nm), the root mean square (RMS) in the green wavelength band (G/Y, 480 nm to 590 nm) may have the lowest value. This is because the human eye is most sensitive in the green wavelength band (G/Y, 480 nm to 590 nm) and thus the natural light similarity in the green wavelength band (G/Y, 480 nm to 590 nm) is important in order to express color temperatures similar to natural light. Therefore, the high color gamut device L2 may have a smaller root mean square (RMS) in the green wavelength band (G/Y, 480 nm to 590 nm) than the light emitting device L1, in which the root mean square (RMS) in the green wavelength band (G/Y, 480 nm to 590 nm) may be less than 20% of the root mean square (RMS) in the entire wavelength region (380 nm to 780 nm). The light emitting device L1 and high color gamut device L2 may also have at least two points in the green wavelength band (G), at which the natural light similarity of the emitted light may have a high value (at which the natural light similarity (S) has a value of 0). To this end, a phosphor having a high color gamut and a great full width at half maximum may be used. To improve the natural light similarity in the green wavelength band (G), the wavelength converter may include a phosphor having a spectrum in the green light region. Furthermore, phosphors having a plurality of different peaks may be used to ensure that the natural light similarity (S) converges on 0.

Furthermore, the wavelength converter 12 may include at least two phosphors having different excitation wavelengths and may include at least two phosphor particles to have different peaks in PL (photoluminescence) measurement of the wavelength converter 12. Here, a region of the phosphor excitation wavelength in PL measurement of the phosphor may overlap with a point at which the natural light similarity of the light emitting device 10, 10' is high (the natural light similarity (S) has a value of 0).

Table 4

| | | | Light emitting device L1 | High color gamut device L2 |
|---|---|---|---|---|
| CCT | | | 6,555 | 6,642 |
| CIE Ra | | | 81 | 98 |
| Natural light similarity (S) | | Minimum | -1.48 | -0.68 |
| | | Maximum | 0.99 | 0.96 |
| | | Std (standard deviation) | 0.516 | 0.406 |
| Minimum value of natural light similarity (S) in each wavelength region | | Blue 400 nm to 480 nm | -1.48 | -0.68 |
| | | Green/Yellow 480 nm to 590 nm | -0.17 | -0.09 |
| | | Orang/Red 590 nm to 750 nm | -0.16 | -0.06 |
| RMS in each wavelength region | | Blue 400 nm to 480 nm | 0.77 | 0.38 |
| | | Green/Yellow 480 nm to 590 nm | 0.21 | 0.04 |
| | | Orang/Red 590 nm to 750 nm | 0.67 | 0.48 |
| RMS | | | 0.66 | 0.48 |

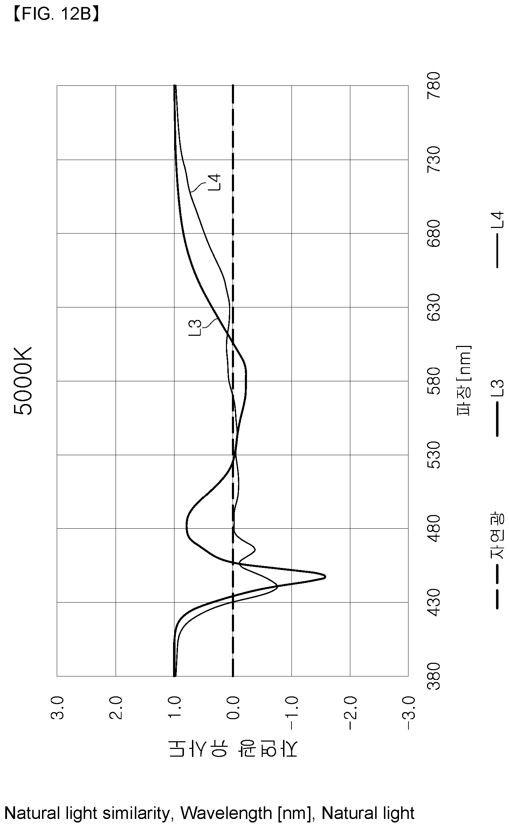

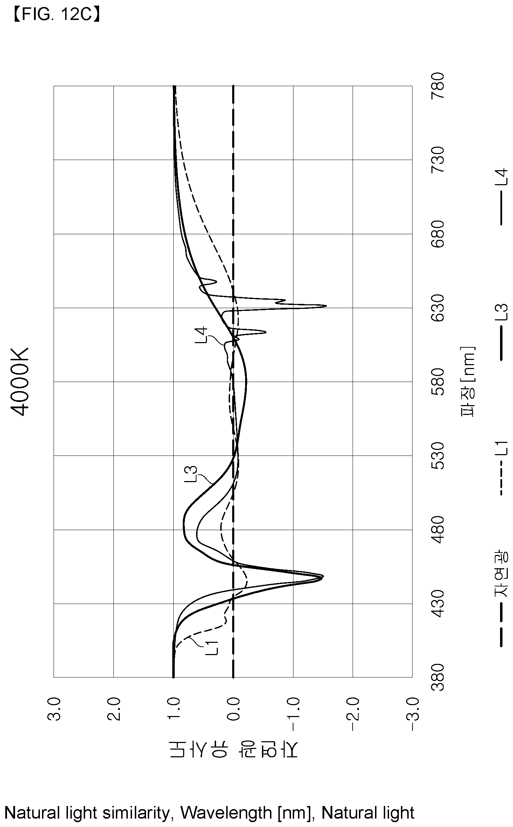

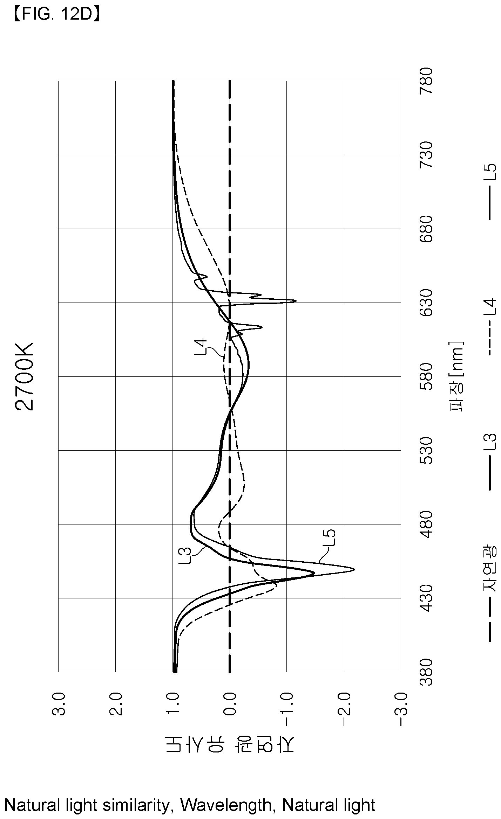

Next, FIG. 12B shows natural light similarity (S) of natural light (ref), a light emitting device L3, and a high color gamut device L4 having an average color rendering index (Ra) of 90 or more at a correlated color temperature of 5,000K, FIG. 12C shows natural light similarity (S) of natural light (ref), a light emitting device L3, and a high color gamut device L4 having an average color rendering index (Ra) of 90 or higher at a correlated color temperature of 4,000K, and FIG. 12D shows natural light similarity (S) of natural light (ref), a light emitting device L3, and a high color gamut device L4 having an average color rendering index (Ra) of 90 or higher at a correlated color temperature of 2,700K.

Similar to FIG. 12A, in FIG. 12B to FIG. 12D, it can be seen that the high color gamut devices L1, L4 have a natural light similarity (S) closer to 0 in all wavelength ranges than the light emitting device L3 to exhibit a spectrum similar to natural light. As a result, it can be seen that the high color gamut devices L1, L4 also have a smaller root mean square (RMS) than the light emitting device at different correlated color temperatures. The high color gamut devices L1, L4 may have a great number of peaks and valleys in the natural light similarity depending on the wavelength and a smaller difference between the peaks and the valleys than the light emitting device L3. The light emitting device L3 can exhibit one or more peaks, whereas the high color gamut devices L1, L4 can exhibit three or more peaks. In addition, the light emitting device L3 may have a difference of 2 or more between the highest peak and the lowest valley in the natural light similarity (S), whereas the high color gamut devices L1, L4 may have a difference of 1 or more between the highest peak and the lowest valley in the natural light similarity (S).

On the other hand, L4 of FIG. 12B, L4 of FIG. 12C, and L5 of FIG. 12D are examples where a wavelength conversion material having two or more peaks is used as a red phosphor in the light emitting device 10, and may also be applied at 6,500K in FIG. 12A. In the red light region R, light emitted from the light emitting device 10 may have at least one point at which the natural light similarity (S) converges on 0. As a result, the light emitting device 10 can reproduce a vivid red color, thereby improving the color rendering index.

The wavelength conversion material having at least two peaks may be realized by KSF phosphors or a wavelength converter including a plurality of wavelength conversion materials, such as CASN, SCASN, or others, and has a high peak in the red wavelength band, thereby providing a relatively high RMS value. Furthermore, a phosphor having a plurality of different peaks may be used such that the natural light similarity (S) converges on 0. In addition, the wavelength converter 12 may include at least two phosphors having different excitation wavelengths and may include two or more phosphor particles to have different peaks in PL measurement of the wavelength converter 12. Here, a region of the phosphor excitation wavelength in PL measurement of the phosphor may overlap a point at which the natural light similarity of the light emitting device 10, 10' is high (the natural light similarity (S) has a value of 0).

Although some exemplary embodiments have been described herein with reference to the accompanying drawings, it should be understood that various modifications and changes can be made by those skilled in the art or by a person having ordinary knowledge in the art without departing from the spirit and scope of the disclosed technology, as defined by the claims and equivalents thereto.

Therefore, the scope of the disclosed technology should be defined only by the appended claims and equivalents thereto rather than by the detailed description of the disclosed technology.

[List of Reference Numerals]

10, 10': Light emitting device
100: Light emitting apparatus
12: Wavelength converter
13: Light transmitting layer
20: Substrate

## Claims

1. A light emitting apparatus comprising at least one light emitting device,

   wherein a natural light similarity (S) of light emitted from the light emitting apparatus is defined by Equation 1:

$$\text{Natural Light Similarity (S)} = 1 - \frac{L(x_k)}{ref(x_k)}, \qquad \text{--- Equation (1)}$$

   where $x_k$ = wavelength,
   $L(x_k)$ = normalized spectral radiant flux of emission light, and
   $ref(x_k)$ = normalized spectral radiant flux of natural light; and
   wherein the natural light similarity (S) ranges from -2.5 to 1.

2. The light emitting apparatus according to claim 1, wherein the wavelength ($x_k$) ranges from 380 nm to 780 nm.

3. The light emitting apparatus according to claim 1, wherein a root mean square (RMS) of the natural light similarity (S) is defined by the equation:

$$\text{Root mean square (RMS)} = \sqrt{\frac{1}{(b-a)} \sum_{k=a}^{b} \left(1 - \frac{L(xk)}{ref(xk)}\right)^2}, \qquad \text{---Equation (2)}$$

   wherein, in Equation 2, a and b are integer numbers representing wavelength limits of the spectrum given in nm, like a = 380 and b = 780,
   and the RMS is less than or equal to 0.8.

4. The light emitting apparatus according to claim 1, wherein the natural light similarity (S) approaches 0 with increasing correlated color temperature (CCT) of the emitted light.

5. The light emitting apparatus according to claim 3, wherein the wavelength ($x_k$) ranges from 380 nm to 780 nm and the root mean square (RMS) has the greatest value in the blue wavelength band ranging from 400nm to 480nm.

6. The light emitting apparatus according to claim 4, wherein the root mean square (RMS) has the lowest value in the green-yellow wavelength band ranging from 480nm to 590nm.

7. The light emitting apparatus according to claim 1, comprising: a plurality of light emitting devices configured to emit light having different correlated color temperatures.

8. The light emitting apparatus according to claim 7, wherein the light emitting device includes a light emitting diode configured to generate light and a wavelength converter covering a light exit surface of the light emitting diode.

9. The light emitting apparatus according to claim 7, further comprising: a controller configured to control a light intensity ratio of the plurality of light emitting devices for each time period of day.

10. The light emitting apparatus according to claim 9, wherein at least one of the plurality of light emitting devices is configured to emit first emission light having a first correlated color temperature and at least one of the remaining light emitting devices is configured to emit second emission light having a second correlated color temperature higher than the first correlated color temperature.

11. The light emitting apparatus according to claim 10, wherein mixed light of the first emission light and the second emission light has a root mean square between a root mean square (RMS) of the first emission light and a root mean square (RMS) of the second emission light.

12. The light emitting apparatus according to claim 1, wherein a root mean square (RMS) of the natural light similarity (S) has the lowest value during a time period of noon.

13. The light emitting apparatus according to claim 1, wherein a root mean square (RMS) of the natural light similarity (S) has the greatest value for a time period of sunrise/sunset.

14. The light emitting apparatus according to claim 1, wherein the light emitting device has an average color rendering index (Ra) of 90 or more.

【FIG. 1】

CIE

【FIG. 2】

Sunrise, Noon, Sunset

【FIG. 3A】

Relative luminous intensity, Wavelength

【FIG. 3B】

【FIG. 3C】

2700K

파장[nm]

【FIG. 4A】

【FIG. 4B】

【FIG. 4C】

【FIG. 4D】

【FIG. 5】

【FIG. 6】

100

【FIG. 7】

☒제1 발광소자  ☒제2 발광소자

Driving ratio, Noon, Daytime, Sunrise/Sunset, First light emitting device, Second light emitting device

【FIG. 8】

Natural light similarity, Wavelength [nm]

【FIG. 9】

Natural light similarity, Wavelength [nm]

【FIG. 10】

Natural light similarity, Wavelength, Mixed light

【FIG. 11A】

Spectral radiant intensity [W/nm], Wavelength [nm]

【FIG. 11B】

Natural light similarity, Wavelength [nm]

【FIG. 12A】

Natural light similarity, Wavelength [nm], Natural light

【FIG. 12B】

Natural light similarity, Wavelength [nm], Natural light

【FIG. 12C】

Natural light similarity, Wavelength [nm], Natural light

【FIG. 12D】

2700K

Natural light similarity, Wavelength, Natural light

Europäisches Patentamt

European Patent Office

Office européen des brevets

## EUROPEAN SEARCH REPORT

**Application Number**

EP 24 21 6140

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/290759 A1 (LI YI-QUN [US] ET AL) 14 September 2023 (2023-09-14) * the whole document * | 1-8, 12-14 | INV. H05B45/20 H05B47/155 H05B47/16 |
| X | WO 2021/194429 A1 (INTRA LIGHTING D O O [SI]; ZAVOD ZA GRADBENISTVO SLOVENIJE [SI]) 30 September 2021 (2021-09-30) * the whole document * | 1-7,9-13 | H01L25/075 |
| X | US 2018/014375 A1 (DUPRAS GABRIEL [CA] ET AL) 11 January 2018 (2018-01-11) * the whole document * | 1-7,9, 12,13 | |

**TECHNICAL FIELDS SEARCHED (IPC)**

H05B
F21V
F21K
F21Y
H01L
H10H

The present search report has been drawn up for all claims

| Place of search | Date of completion of the search | Examiner |
|---|---|---|
| Munich | 7 May 2025 | Ferla, Monica |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 6140

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2025

| Patent document cited in search report | Publication date | Patent family member(s) | | Publication date |
|---|---|---|---|---|
| US 2023290759 A1 | 14-09-2023 | US | 2023290759 A1 | 14-09-2023 |
| | | US | 2025054919 A1 | 13-02-2025 |
| WO 2021194429 A1 | 30-09-2021 | EP | 4129007 A1 | 08-02-2023 |
| | | SI | 25985 A | 30-09-2021 |
| | | WO | 2021194429 A1 | 30-09-2021 |
| US 2018014375 A1 | 11-01-2018 | CA | 2974997 A1 | 04-08-2016 |
| | | CN | 107432069 A | 01-12-2017 |
| | | US | 2018014375 A1 | 11-01-2018 |
| | | WO | 2016119063 A1 | 04-08-2016 |

EPO FORM P0459

For more details about this annex : see Official Journal of the European Patent Office, No. 12/82